(19) Europäisches Patentamt
European Patent Office
Office européen des brevets

(11) **EP 2 717 304 A1**

(12) **EUROPEAN PATENT APPLICATION**
published in accordance with Art. 153(4) EPC

(43) Date of publication:
**09.04.2014 Bulletin 2014/15**

(51) Int Cl.:
**H01L 21/52** (2006.01)  **C09J 11/04** (2006.01)
**C09J 163/00** (2006.01)  **C09J 201/00** (2006.01)

(21) Application number: **12793698.7**

(22) Date of filing: **28.05.2012**

(86) International application number:
**PCT/JP2012/063631**

(87) International publication number:
**WO 2012/165375 (06.12.2012 Gazette 2012/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2011 JP 2011121386**

(71) Applicant: **Sumitomo Bakelite Company Limited Tokyo 140-0002 (JP)**

(72) Inventors:
• **MURAYAMA Ryuichi**
**Tokyo 140-0002 (JP)**

• **SHIMOBE Yasuo**
**Tokyo 140-0002 (JP)**
• **KANAMORI Naoya**
**Tokyo 140-0002 (JP)**

(74) Representative: **Schnappauf, Georg**
**ZSP Patentanwälte**
**Partnerschaftsgesellschaft**
**Radlkoferstrasse 2**
**81373 München (DE)**

(54) **RESIN COMPOSITION, SEMICONDUCTOR DEVICE USING SAME, AND METHOD OF MANUFACTURING SEMICONDUCTOR DEVICE**

(57)   According to the present invention, a resin composition having superior workability is provided. The paste-like resin composition of the present invention adheres a semiconductor element and a base material, and contains (A) a thermosetting resin and (B) metal particles. $d_{95}$ in the volume-based particle size distribution of the metal particles as determined with a flow-type particle image analyzer is 10 $\mu$m or less. In other words, the volume ratio of metal particles having a particle diameter that exceeds 10 $\mu$m is less than 5%. Here, $d_{95}$ indicates the particle diameter at which the cumulative volume ratio thereof is 95%.

FIG. 1

EP 2 717 304 A1

**Description**

TECHNICAL FIELD

The present invention relates to a resin composition, a semiconductor device using the same, and a manufacturing method of a semiconductor device.

The present application claims priority on the basis of Japanese Patent Application No. 2011-121386, filed in Japan on May 31, 2011, the contents of which are incorporated herein by reference.

BACKGROUND ART

In semiconductor devices, a semiconductor element is fixed through an adhesive layer on a base material such as a lead frame, heat sink or substrate. This adhesive layer is required to be electrically conductive and thermally conductive in addition to having adhesiveness, and is known to able to be formed by a paste-like resin composition containing metal particles. For example, Patent Documents 1 and 2 describe the formation of the aforementioned adhesive layer with a paste-like resin composition containing silver particles.

Citation List

Patent Literature

Patent Document 1: Japanese Unexamined Patent Application, First Publication No. H05-89721
Patent Document 2: Japanese Unexamined Patent Application, First Publication No. H07-118616

SUMMARY OF INVENTION

Problems to be Solved by the Invention

This type of resin composition contains a large number of metal particles for obtaining desired electrical conductivity and thermal conductivity. Since the containing of a large number of metal particles increases the viscosity of the resin composition and makes coating difficult, it is necessary to lower the viscosity of the resin used.

However, since metal particles have a larger specific gravity than the resin component, lowering resin viscosity increases the sedimentation rate of the metal particles during use and storage. Consequently, resin compositions containing a large number of metal particles were difficult to handle due to their instability and considerable changes in viscosity over time.

On the other hand, when adhering a semiconductor element such as a light-emitting diode element or semiconductor laser element having a narrow chip width, it is necessary to coat a small amount of a resin composition on a base material while maintaining favorable accuracy with respect to thickness, and the resin composition is coated by stamping or dispensing with an extremely fine needle and the like.

Since the aforementioned resin composition undergoes a considerable change in viscosity when allowed to stand after spreading out in the form of a thin film on a glass plate and the like, there are cases in which stamping cannot be carried out properly. In addition, since the aforementioned resin composition ends up clogging the extremely fine needle as a result of undergoing an increase in viscosity within the needle, there are cases in which the resin cannot be discharged properly. Thus, a resin composition containing a large number of metal particles was particularly unsuitable for adhering semiconductor elements having a narrow chip width to a base material.

On the other hand, Patent Document 2 describes that sedimentation of silver particles can be suppressed by containing spherical silica having a mean particle diameter of 0.1 $\mu$m to 1.0 $\mu$m in a resin composition in which silver particles are dispersed in a thermosetting resin. However, since spherical silica has insulating properties, there are cases in which electrical conductivity becomes poor when they are contained in an adhesive layer. In addition, although the same publication describes that effects that suppress sedimentation of metal particles can be obtained to a certain degree by reducing the particle diameter of the silver particles, the paste ends up increasing in viscosity, thereby resulting in poor coating workability.

With the foregoing in view, an object of the present invention is to provide a resin composition having superior workability.

As a result of extensively investigating the mechanism by which the viscosity of a resin composition changes over time, the inventors of the present invention determined that these changes in viscosity are caused by metal particles having a particle diameter in excess of 10 $\mu$m, thereby leading to completion of the present invention.

Means for Solving the Problem

Namely, according to the present invention,
a paste-like resin composition is provided that adheres a semiconductor element and a base material, comprising:
a thermosetting resin, and
metal particles; wherein,
$d_{95}$ in the volume-based particle size distribution of the metal particles as determined with a flow-type particle image analyzer is 10 $\mu$m or less.

The value of $d_{95}$ of metal particles contained in the resin composition is 10 $\mu$m or less, or in other words, by making the volume ratio of metal particles having a particle diameter in excess of 10 $\mu$m to be less than 5%, there is less likelihood of the metal particles undergoing sedimentation. Consequently, the resin composition of the present invention undergoes little change in viscosity over time and has superior workability.

Moreover, according to the present invention:

a semiconductor device is provided that is provided with:

the base material,
the semiconductor element, and
an adhesive layer that adheres the base material and the semiconductor element while interposed there between; wherein,
the adhesive layer is formed using the resin composition.

Moreover, according to the present invention:

a method of manufacturing a semiconductor device is provided, comprising:

a step for coating the resin composition onto at least one adhered side of the semiconductor element or the base material, and
a step for forming the adhesive layer by compression bonding the semiconductor element and the base material followed by heat curing.

Effects of the Invention

According to the present invention, a resin composition is provided that has superior workability.

BRIEF DESCRIPTION OF DRAWINGS

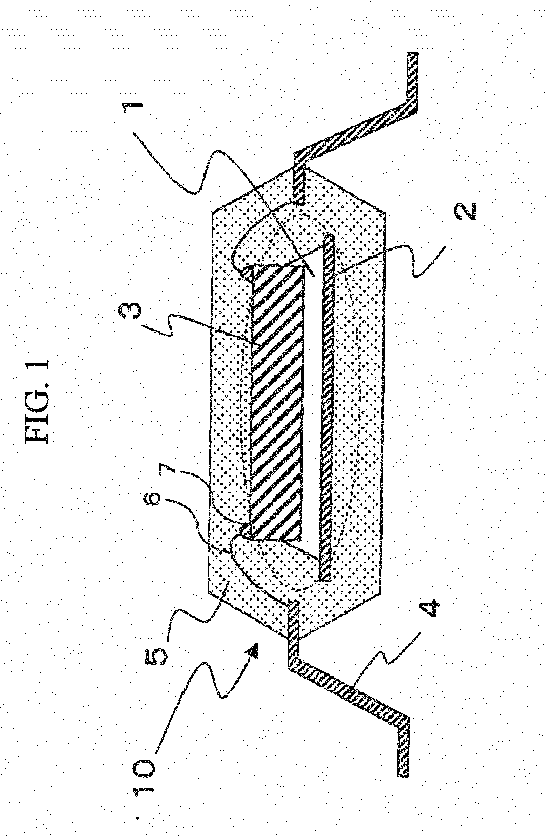

FIG. 1 is a cross-sectional view showing the configuration of a semiconductor device according to the present embodiment.

DESCRIPTION OF EMBODIMENTS

The following provides an explanation of embodiments of the present invention.

(Resin Composition)

The paste-like resin composition in the present embodiment adheres a semiconductor element and a base material, and contains (A) a thermosetting resin and (B) metal particles. The metal particles (B) have a value of $d_{95}$ in the volume-based particle size distribution as determined with a flow-type particle image analyzer of 10 $\mu$m or less. In other words, the volume ratio of metal particles having a particle diameter in excess of 10 $\mu$m is less than 5%.

Here, $d_{95}$ indicates the particle diameter at which the cumulative volume ratio is 95%.

If the value of $d_{95}$ of the metal particles (B) contained in the resin composition is 10 $\mu$m or less, the metal particles (B) are favorably dispersed in the resin composition and are unlikely to undergo sedimentation. Accordingly, the resin composition in the present embodiment undergoes little change in viscosity and has superior workability.

In addition, when adhering a semiconductor element such as a light-emitting diode element or semiconductor laser element having a narrow chip width to a base material, it is necessary to coat a small amount of resin composition onto the base material while maintaining favorable accuracy with respect to thickness by stamping of dispensing from an extremely fine needle. The resin composition used for stamping is required to undergo little change in viscosity over time on a glass plate and the like, and the resin composition used for dispensing from an extremely fine needle is required to not cause the resin composition to clog in the needle.

Since the resin composition in the present embodiment undergoes little change in viscosity and has superior workability, a small amount of the resin composition can be coated onto a base material while maintaining favorable accuracy with respect to thickness by stamping or by dispensing from an extremely fine needle. Consequently, although there are no particular limitations thereon, the resin composition in the present embodiment is particularly suitable for adhering a semiconductor element such as a light-emitting diode element or semiconductor laser element having a narrow chip width to a base material.

(Thermosetting Resin)

The thermosetting resin (A) is an ordinary thermosetting resin that forms a three-dimensional network structure when heated. Although there are no particular limitations thereon, this thermosetting resin (A) is preferably a material that forms a liquid resin composition, and is preferably a liquid at room temperature. Examples thereof include cyanate resin, epoxy resin, resins having two or more radical-polymerizable carbon-carbon double bonds in a molecule thereof, and maleimide resin.

A cyanate resin according to the thermosetting resin (A) is a compound having an -NCO group in a molecule thereof that is a resin that cures by forming a three-dimensional network structure due to reaction of the -NCO group when heated, and is a curable multifunctional cyanate compound or low molecular weight polymer thereof. Examples of cyanate resins according to the thermosetting resin (A) include, but are not limited to, reaction such as 1,3-dicyantobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanophenyl)methane, bis(3,5-dimethyl-4-cyantophenyl)methane, 2,2-bis(4-cyanatophenyl)propane, 2,2-bis(3,5-dibromo-4-cyanatophenyl)propane, bis(4-cyanatophenyl)ether, bis(4-cyanatophenyl)thioether, bis(4-cyanatophenyl)sulfone, tris(4-cyanatophenyl)phosphite or tris(4-cyanatophenyl)phosphate, cyanates obtained by reacting novolac resins and cyanogen halides, and prepolymers having a triazine ring formed by trimerizing a cyanate group of these multifunctional cyanate resins. These prepolymers are obtained by polymerizing the aforementioned multifunctional cyanate resin monomers by using as a catalyst an acid such as an organic acid or Lewis acid, a base such as a sodium alcoholate or tertiary amine, or a salt such as sodium carbonate.

Examples of curing accelerators of the cyanate resin according to the thermosetting resin (A) include ordinary known curing accelerators. Examples thereof include, but are not limited to, organometallic complexes such as zinc octylate, tin octylate, cobalt naphthenate, zinc naphthenate or iron acetylacetonate, metal salts such as aluminum chloride, tin chloride or zinc chloride, and amines such as triethylamine or dimethylbenzylamine. One type of these curing accelerators may be used alone or two or more types may be used in combination.

In addition, a cyanate resin can also be used in combination with other resins such as epoxy resin, oxetane resin, resins having two or more radical-polymerizable carbon-carbon double bonds in a molecule thereof or maleimide resin.

An epoxy resin according to the thermosetting resin (A) is a compound having one or more glycidyl groups in a molecule thereof that cures by forming a three-dimensional network structure due to reaction of the glycidyl groups when heated. Although the epoxy resin according to the thermosetting resin (A) preferably contains two or more glycidyl groups in a molecule thereof, this is because reacting a compound containing only one glycidyl group prevents the demonstration of adequate properties by the cured product.

Among epoxy resins according to the thermosetting resin (A), examples of compounds containing two or more glycidyl groups in a molecule thereof include, but are not limited to, bifunctional compounds obtained by epoxidizing bisphenol compounds such as bisphenol A, bisphenol F or biphenol or derivatives thereof, diols having an alicyclic structure such as hydrogenated bisphenol A, hydrogenated bisphenol F, hydrogenated biphenyl, cyclohexanediol, cyclohexanedimethanol or cyclohexanediethanol or derivatives thereof, or aliphatic diols such as butanediol, hexanediol, octanediol, nonanediol or decanediol or derivatives thereof, epoxidized trifunctional compounds having trihydroxyphenylmethane backbone or aminophenyl backbone, and multifunctional compounds obtained by epoxidizing compounds such as phenol novolac resins, cresol novolac resins, phenyl aralkyl resins, biphenyl aralkyl resins or naphthol aralkyl resins. Since the resin composition is preferably a liquid at room temperature, the epoxy resin according to the thermosetting resin (A) is preferably a liquid at room temperature either alone or as a mixture. An example of a method used to epoxidize a diol or derivative thereof consists of reacting two hydroxyl groups of the diol or derivative thereof with epichlorhydrin to convert to glycidyl ether. In addition, a similar method can be used for compounds having three or more functional groups.

A reactive diluent can also be used in the manner in which it is ordinarily used. Examples of reactive diluents include monofunctional aromatic glycidyl ethers and aliphatic glycidyl ethers such as phenyl glycidyl ether, tertiary-butyl phenyl glycidyl ether or cresyl glycidyl ether.

In the case the aforementioned epoxy resin according to the thermosetting resin (A) is used for the thermosetting resin (A), the resin composition in the present embodiment contains a curing agent in order to cure the epoxy resin.

Examples of curing agents of the epoxy resin according to the thermosetting resin (A) include aliphatic amines, aromatic amines, dicyandiamides, dihydrazide compounds, acid anhydrides and phenol resins.

Examples of dihydrazide compounds used as a curing agent of the epoxy resin according to the thermosetting resin (A) include carbonic dihydrazides such as adipic dihydrazide, dodecanoic dihydrazide, isophthalic dihydrazide or p-oxybenzoic dihydrazide.

Examples of acid anhydrides used as a curing agent of the epoxy resin include phthalic anhydride, tetrahydrophthalic anhydride, hexahydrophthalic anhydride, 4-methylhexahydrophthalic anhydride, endomethylene tetrahydrophthalic anhydride, dodecenyl succinic anhydride and maleic anhydride.

A phenol resin used as a curing agent of the epoxy resin according to the thermosetting resin (A) is a compound having two or more phenolic hydroxyl groups in a molecule thereof. Properties of the cured product become poor preventing its use as a result of being unable to adopt a crosslinked structure in the case of a compound having only one phenolic hydroxyl group in a molecule thereof. In addition, although a phenol resin used as a curing agent of the epoxy resin according to the thermosetting resin (A) is required to have two or more phenolic hydroxyl groups in a molecule thereof, it preferably has 2 or more and 5 or less phenolic hydroxyl groups in a molecule thereof, and more preferably has two or three phenolic hydroxyl groups in a molecule thereof. In the case the number of phenolic hydroxyl groups is greater than this, molecular weight becomes excessively high, thereby causing the viscosity of the resin composition to become excessively high, making this undesirable. Examples of such compounds include bisphenols and derivatives thereof such as bisphenol F, bisphenol A, bisphenol S, tetramethyl bisphenol A, tetramethyl bisphenol F, tetramethyl bisphenol S, dihydroxydiphenyl ether, dihydroxybenzophenone, tetramethyl biphenol, ethylidene bisphenol, methylethylidene bis(methylphenol), cyclohexylidene bisphenol or biphenol, trifunctional phenols and derivatives thereof such as tri(hydroxyphenyl)methane or tri(hydroxyphenyl)ethane, and compounds consisting mainly of dikaryons or trikaryons and derivatives thereof obtained by reacting formaldehyde with a phenol such as phenol novolac or cresol novolac.

Although examples of curing accelerators of the epoxy resin according to the thermosetting resin (A) include imidazoles, salts of triphenylphosphine or tetraphenylphosphonium and amine-based compounds such as diazabicycloundecene and salts thereof, imidazole compounds such as 2-methylimidazole, 2-ethylimidazole-2-phenylimidazole, 2-phenyl-4-methylimidazole, 2-phenyl-4-methyl-5-hydroxymethylimidazole, 2-phenyl-4,5-dihydroxymethylimidazole, 2-$C_{11}H_{23}$-imidazole and adducts of 2-methylimidazole and 2,4-diamino-6-vinyltriazine are preferable. Among these, imidazole compounds having a melting point of 180°C or higher are particularly preferable. In addition, the epoxy resin is preferably used in combination with a cyanate resin, resin having two or more radical-polymerizable carbon-carbon double bonds in a molecule thereof or maleimide resin.

A resin having two or more radical-polymerizable carbon-carbon double bonds in a molecule thereof according to the thermosetting resin (A) refers to a compound having carbon-carbon double bonds in a molecule thereof that is a resin that cures by forming a three-dimensional network structure as a result of reaction of the carbon-carbon double bonds.

The molecular weight of the thermosetting resin (A) in a resin having two or more radical-polymerizable carbon-carbon double bonds in a molecule thereof according to the thermosetting resin (A) is preferably 500 or more and 50,000 or less. This is because if the molecular weight is lower than the aforementioned range, the elastic modulus of the adhesive layer becomes excessively high, while if the molecular weight is higher than the aforementioned range, viscosity of the resin composition becomes excessively high.

The following indicates preferable examples of resins having two or more radical-polymerizable carbon-carbon double bonds in a molecule thereof, although not limited thereto.

A compound having two or more acrylic groups in a molecule thereof is preferably a polyether, polyester, polycarbonate, poly(meth)acrylate, polybutadiene or a butadiene-acrylonitrile copolymer having two or more acrylic groups in a molecule thereof, having a molecular weight of 500 or more and 50,000 or less.

The polyether is preferably that having repeating organic groups having 3 to 6 carbon atoms bonded through ether bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5,000 or less and particularly preferably 500 or more 2,000 or less. This is because, if the molecular weight is within the aforementioned ranges, an adhesive layer is obtained that has favorable workability and low elastic modulus. This type of polyether compound having two or more acrylic groups in a molecule thereof can be obtained by reacting a polyether polyol with (meth)acrylic acid or a derivative thereof.

The polyester is preferably that having repeating organic groups having 3 to 6 carbon atoms bonded through ester bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5,000 or less and particularly preferably 500 or more and 2,000 or less. This is because, if the molecular weight is within the aforementioned ranges, an adhesive layer is obtained that has favorable workability and low elastic modulus. This type of polyester compound having two or more acrylic groups in a molecule thereof can be obtained by reacting a polyester polyol with (meth)acrylic acid or a derivative thereof.

The polycarbonate is preferably that having repeating organic groups having 3 to 6 carbon atoms bonded through carbonate bonds, and preferably does not contain an aromatic ring. This is because, in the case of containing an aromatic ring, the compound having two or more acrylic groups in a molecule thereof becomes a solid or highly viscous, and the elastic modulus in the case of obtaining a cured product becomes excessively high. In addition, although the molecular weight of a compound having two or more acrylic groups in a molecule thereof is preferably 500 or more and 50,000 or less as previously described, it is more preferably 500 or more and 5, 000 or less and particularly preferably 500 or more and 2, 000 or less. This is because, if the molecular weight is within the aforementioned ranges, an adhesive layer is obtained that has favorable workability and low elastic modulus. This type of polycarbonate compound having two or more acrylic groups in a molecule thereof can be obtained by reacting a polycarbonate polyol with (meth)acrylic acid or a derivative thereof.

The poly(meth)acrylate is preferably a copolymer of (meth)acrylic acid and (meth)acrylate, a copolymer of a (meth) acrylate having a hydroxyl group and a (meth) acrylate not having a polar group, or a copolymer of a (meth) acrylate having a glycidyl group and a (meth) acrylate not having a polar group. In addition, although the molecular weight of a compound having two or more acrylic groups in a molecule thereof is preferably 500 or more and 50,000 or less as previously described, it is more preferably 500 or more and 25,000 or less. This is because, if the molecular weight is within the aforementioned ranges, an adhesive layer is obtained that has favorable workability and low elastic modulus. This type of (meth) acrylate compound having two or more acrylic groups in a molecule thereof can be obtained by reacting with a (meth)acrylate having a hydroxyl group or a (meth)acrylate having a glycidyl group in the case of a copolymer having a carboxyl group, reacting with (meth)acrylic acid or derivative thereof in the case of a copolymer having a hydroxyl group, or reacting with (meth)acrylic acid or derivative thereof in the case of a polymer having a glycidyl group.

The polybutadiene can be obtained by reacting polybutadiene having a carboxyl group with a (meth) acrylate having a hydroxyl group or a (meth)acrylate having a glycidyl group, or by reacting polybutadiene having a hydroxyl group with (meth)acrylic acid or a derivative thereof, and can also be obtained by reacting polybutadiene to which maleic anhydride has been added with a (meth)acrylate having a hydroxyl group.

The butadiene-acrylonitrile copolymer can be obtained by reacting a butadiene-acrylonitrile copolymer having a carboxyl group with a (meth)acrylate having a hydroxyl group or a (meth)acrylate having a glycidyl group.

A compound having two or more allyl groups in a molecule thereof is preferably a polyether, polyester, polycarbonate, polyacrylate, polymethacrylate, polybutadiene or butadiene-acrylonitrile copolymer having an allyl group, having a molecular weight of 500 or more and 50,000 or less, and examples thereof include reaction products of diallyl ester compounds, obtained by reacting an allyl alcohol with a dicarboxylic acid in the manner of oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid or hexahydrophthalic acid and derivatives thereof, and diols in the manner of ethylene glycol, propylene glycol or tetramethylene glycol.

Preferable examples of compounds having two or more maleimide groups in a molecule thereof include bismaleimide compounds such as N,N'-(4,4'-diphenylmethane)bismaleimide, bis(3-ethyl-5-methyl-4-maleimidophenyl)methane or 2,2-bis[4-(4-maleimidophenoxy)phenyl]propane. More preferable examples include compounds obtained by reacting a dimer acid diamine with maleic anhydride, and compounds obtained by reacting a polyol with a maleimidized amino acid in the manner of maleimidoacetic acid or maleimidocaproic acid. Maleimidized amino acids are obtained by reacting maleic anhydride with aminoacetic acid or aminocaproic acid, a polyether polyol, polyester polyol, polycarbonate polyol, polyacrylate polyol or polymethacrylate polyol is preferable for the polyol, and that not containing an aromatic ring is particularly preferable. This is because, in the case of containing an aromatic ring, the compound having two or more maleimide groups in a molecule thereof becomes a solid or highly viscous, and the elastic modulus in the case of obtaining a cured product becomes excessively high.

In addition, the following compounds can be used within a range that does not impair the effects of the thermosetting resin (A) to adjust various properties of the thermosetting resin in the present embodiment. Examples thereof include (meth) acrylates having a hydroxyl group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, glycerin mono(meth)acrylate, glycerin di(meth)acrylate, trimethylolpropane mono(meth)acrylate, trimethylolpropane di(meth)acrylate; pentaerythritol mono(meth)acrylate, pentaerythritol di(meth)acrylate, pentaerythritol tri(meth)acrylate or neopentyl glycol mono(meth)acrylate, and (meth)acrylates having a carboxyl group obtained by reacting these (meth)acrylates having a hydroxyl group with a dicarboxylic acid or derivative thereof. Here, examples of dicarboxylic acids that can be used include oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid, hexahydrophthalic acid and derivatives thereof.

In addition to the compounds described above, examples of other compounds that can be used include methyl (meth) acrylate, ethyl (meth)acrylate, n-butyl (meth)acrylate, isobutyl (meth)acrylate, tertiary-butyl (meth)acrylate, isodecyl (meth)acrylate, lauryl (meth)acrylate, tridecyl (meth)acrylate, 2-ethylhexyl (meth)acrylate, other alkyl (meth)acrylates, benzyl (meth)acrylate, phenoxyethyl (meth)acrylate, glycidyl (meth)acrylate, trimethylolpropane tri(meth)acrylate, zinc mono(meth)acrylate, zinc di(meth)acrylate, dimethylaminoethyl (meth)acrylate, diethylaminoethyl (meth)acrylate, neopentyl glycol (meth)acrylate, trifluoromethyl (meth)acrylate, 2,2,3,3-tetrafluoropropyl (meth)acrylate, 2,2,3,3,4,4-hexafluorobutyl (meth)acrylate, perfluorooctyl (meth)acrylate, perfluorooctylethyl (meth)acrylate, ethylene glycol di(meth)acrylate, propylene glycol di(meth)acrylate, 1,4-butanediol di(meth)acrylate, 1,6-hexanediol di(meth)acrylate, 1,9-nonanediol di(meth)acrylate, 1,3-butanediol di(meth)acrylate, 1,10-decanediol di(meth)acrylate, tetramethylene glycol di(meth)acrylate, methoxyethyl (meth)acrylate, butoxyethyl (meth)acrylate, ethoxydiethylene glycol (meth)acrylate, N,N'-methylenebis(meth)acrylamide, N,N'-ethylenebis(meth)acrylamide, 1,2-di(meth)acrylamide ethylene glycol, di(meth)acryloyloxy methyltricyclodecane, N-(meth)acryloyloxy ethylmaleimide, N-(meth)acryloyloxy ethylhexahydrophthalimide, N-(meth)acryloyloxy ethylphthalimide, n-vinyl-2-pyrrolidone, styrene derivatives and α-methylstyrene derivatives.

Moreover, a thermal radical polymerization initiator is preferably used as a polymerization initiator of a resin having two or more radical-polymerizable carbon-carbon double bonds in a molecule thereof according to the thermosetting resin (A). Although there are no particular limitations on the thermal radical polymerization initiator provided it is normally used as a thermal radical polymerization initiator, it preferably has a decomposition temperature of 40°C or more and 140°C or less in a rapid heating test (decomposition starting temperature when 1 g of sample is placed on an electric heating plate and the temperature is raised at the rate of 4°C/minute). If the decomposition temperature is lower than 40°C, storageability of the resin composition at normal temperatures becomes poor, while if the decomposition temperature exceeds 140°C, curing time becomes extremely long, thereby making this undesirable.

Specific examples of thermal radical polymerization initiators that satisfy this requirement include methyl ethyl ketone peroxide, methyl cyclohexanone peroxide, methyl acetoacetate peroxide, acetyl acetone peroxide, 1,1-bis(t-butylperoxy)3,3,5-trimethylcyclohexane, 1,1-bis(t-hexylperoxy)cyclohexane, 1,1-bis(t-hexylperoxy)3,3,5-trimethylcyclohexane, 1,1-bis(t-butylperoxy) cyclohexane, 2,2-bis(4,4-di-t-butylperoxycyclohexyl)propane, 1,1-bis(t-butylperoxy)cyclodecane, n-butyl-4,4-bis(t-butylperoxy)valerate, 2,2-bis(t-butylperoxy)butane, 1,1-bis(t-butylperoxy)-2-methylcyclohexane, t-butylhydroperoxide, p-menthanehydroperoxide, 1,1,3,3-tetramethylbutylhydroperoxide, t-hexylhydroperoxide, dicumylperoxide, 2,5-dimethyl-2,5-bis(t-butylperoxy)hexane, α,α'-bis(t-butylperoxy)diisopropylbenzene, t-butylcumylperoxide, di-t-butylperoxide, 2,5-dimethyl-2,5-bis(t-butylperoxy)-3-hexane, isobutyryl peroxide, 3,5,5-trimethylhexanoyl peroxide, octanoyl peroxide, lauroyl peroxide, cinnamoyl peroxide, m-toluyl peroxide, benzoyl peroxide, diisopropyl peroxycarbonate, bis(4-t-butylcyclohexyl)peroxycarbonate, di-3-methoxybutylperoxycarbonate, di-2-ethylhexylperoxycarbonate, di-sec-butylperoxycarbonate, di(3-methyl-3-methoxybutyl)peroxycarbonate, di(4-t-butylcyclohexyl)peroxycarbonate, α,α'-bis(neodecanoylperoxy)diisopropylbenzene, cumylperoxyneodecanoate, 1,1,3;3-tetramethylbutylperoxyneodecanoate, 1-cyclohexyl-1-methylethylperoxyneodecanoate, t-hexylperoxyneodecanoate, t-butylperoxyneodecanoate, t-hexylperoxypivalate, t-butylperoxypivalate, 2,5-dimethyl-2,5-bis(2-ethylhexanoylperoxy)hexane, 1,1,3,3-tetramethylbutylperoxy-2-ethylhexanoate, 1-cyclohexyl-1-methylethylperoxy-2-ethylhexanoate, t-hexylperoxy-2-ethylhexanoate, t-butylperoxy-2-ethylhexanoate, t-butylperoxyisobutyrate, t-butylperoxymaleic acid, t-butylperoxylaurate, t-butylperoxy-3,5,5-trimethylhexanoate, t-butylperoxyisopropyl monocarbonate, t-butylperoxy-2-ethylhexyl monocarbonate, 2,5-dimethyl-2,5-bis(benzoylperoxy)hexane, t-butylperoxyacetate, t-hexylperoxybenzoate, t-butylperoxy-m-tolylbenzoate, t-butylperoxybenzoate, bis(t-butylperoxy) isophthalate, t-butylperoxyallyl monocarbonate and 3,3',4,4'-tetra(t-butylperoxycarbonyl) benzophenone, and these can be used alone or two or more types thereof can be used as a mixture to control curability. In addition, the aforementioned resin having two or more radical-polymerizable carbon-carbon double bonds in a molecule thereof is preferably used in combination with a cyanate resin, epoxy resin or maleimide resin.

A maleimide resin according to the thermosetting resin (A) is a compound containing one or more maleimide groups in a molecule thereof that cures by forming a three-dimensional network structure as a result of the maleimide groups reacting when heated. Examples thereof include bismaleimide resins such as the reaction products of N,N'-(4,4'-diphenylmethane)bismaleimide, bis(3-ethyl-5-methyl-4-maleimidophenyl)methane or 2,2-bis[4-(4-maleimidophenoxy)phenyl]propane. The maleimide resin according to the thermosetting resin (A) is more preferably a compound obtained by a reaction between a dimer acid diamine and maleic anhydride, or a compound obtained by reaction between a maleimidized amino acid and a polyol in the manner of maleimidoacetic acid or maleimidocaproic acid. Maleimidized amino acids are obtained by reacting maleic anhydride with aminoacetic acid or aminocaproic acid, polyether polyol, polyester polyol, polycarbonate polyol, polyacrylate polyol or polymethacrylate polyol is preferable for the polyol, and that not containing an aromatic ring is particularly preferable. Since a maleimide group can be reacted with an allyl group, it is preferably used in combination with an allyl ester resin. An aliphatic allyl ester resin is preferable, and compounds obtained by transesterification between a cyclohexane diallyl ester and an aliphatic polyol are particularly preferable. In addition, it is preferably used in combination with a cyanate resin, epoxy resin or acrylic resin.

The incorporated amount of the thermosetting resin (A) is 2% by weight or more and 40% or less by weight and preferably 5% by weight or more and 35% or less by weight in the entire resin composition. As a result of being within these ranges, workability, heat resistance and the like of the resin composition are even more superior.

(Metal Particles)

Although there are no particular limitations on the metal particles (B) provided the $d_{95}$ value thereof is 10 μm or less, they are preferably silver particles since silver particles have superior electrical conductivity and thermal conductivity. In addition to silver, at least one or more types of metals composed of, for example, copper, gold, nickel, palladium, aluminum, tin or zinc, or alloy particles of these metals, can also be used.

Here, silver particles include metal particles in which the surface of metal particles composed of copper, gold, nickel, palladium, aluminum, tin or zinc and the like is coated with silver.

Although there are no particular limitations on the shape of the metal particles (B), they are preferably flaked or ellipsoid. If the shape of the metal particles is flaked or ellipsoid, the resulting adhesive layer has particularly superior thermal conductivity and electrical conductivity.

In addition, although varying according to the required viscosity of the resin composition, the particle diameter of the metal particles (B) is normally such that the median diameter $d_{50}$ of the metal particles in a volume-based particle size distribution as determined with a flow-type particle image analyzer is preferably 0.5 μm or more and 8 μm or less and more preferably 0.6 μm or more 6 μm or less. In the case the median diameter $d_{50}$ is less than 0.5 μm, viscosity becomes high, while if the median diameter $d_{50}$ exceeds 8 μm, the resin component easily flows out during coating or curing resulting in bleeding, thereby making this undesirable. In addition, if the median diameter $d_{50}$ exceeds 8 μm, the outlet of a needle may be blocked, thereby preventing long-term continuous use when coating the resin composition with a dispenser. Moreover, the particle size distribution of the metal particles preferably has only one peak (monophasic):

In addition, the content of ionic impurities such as halogen ions or alkaline metal ions in the metal particles (B) used is preferably 10 ppm or less. Furthermore, the surface of the metal particles (B) used in the present embodiment may be pretreated with a silane coupling agent such as alkoxysilane, acyloxysilane, silazane or organoaminosilane.

In addition, the incorporated amount of the metal particles (B) is preferably 50 parts by weight or more and 95 parts by weight or less and more preferably 60 parts by weight or more and 90 parts by weight or less based on 100 parts by weight of the entire resin composition. As a result of the incorporated amount being within these ranges, favorable thermal conductivity and electrical conductivity can be obtained, and workability is also superior. In the case the incorporated amount of metal particles (B) in the resin composition is less than 50 parts by weight, the metal particles (B) may be unable to impart an alignment parallel to the direction of gravity when coated with the thermosetting resin (A), while if the incorporated amount exceeds 95 parts by weight, the viscosity of the resin composition becomes high and workability decreases, and since a cured product of the resin composition may also become brittle, soldering resistance may decrease, thereby making this undesirable.

(Insulating Particles)

In addition, the resin composition in the present embodiment may further contain insulating particles (C). Although there are no particular limitations thereon, examples of the insulating particles (C) include inorganic fillers such as silica particles or inorganic fillers such as alumina and organic fillers such as organic polymers.

The insulating particles (C) are preferably able to cause the metal particles (B) contained to align, and in the case of using in semiconductor applications, those having a uniform particle diameter are even more preferable. In addition, the insulating particles (C) are more preferably particles for maintaining a constant thickness of an adhesive layer 1 after curing by imparting a low coefficient of thermal expansion or low coefficient of moisture absorption and the like to the adhesive layer 1 in the present embodiment.

In addition, although there are no particular limitations thereon, the $d_{95}$ value of the insulating particles (C) in a volume-based particle size distribution as determined with a flow-type particle image analyzer is preferably 10 μm or less. If the $d_{95}$ value of the insulating particles (C) contained in the resin composition is 10 μm or less, the insulating particles (C) and the metal particles (B) become even less susceptible to sedimentation and aggregation, thereby resulting in even more superior workability.

In addition, although varying according to the required viscosity of the resin composition, the particle diameter of the insulating particles (C) is normally such that the median diameter $d_{50}$ of a particle size distribution of the insulating particles (C) as determined with a flow-type particle image analyzer is preferably 2 μm or more and 8 μm or less and more preferably 3 μm or more and 7 μm or less. In the case the median diameter $d_{50}$ is less than 2 μm, viscosity becomes high thereby making this undesirable. In addition, if the median diameter $d_{50}$ is 2 μm or more, the long axis of the metal particles (B) becomes parallel to the direction of gravity, thereby enabling them to be aligned more efficiently.

In addition, if the median diameter $d_{50}$ exceeds 8 μm, the resin component easily flows out during coating or curing resulting in bleeding, thereby making this undesirable. In addition, if the median diameter $d_{50}$ is 8 μm or less, the long axis of the metal particles (B) becomes parallel to the direction of gravity, thereby enabling them to be aligned more efficiently.

In addition, the incorporated amount of the insulating particles (C) is preferably 5 parts by weight or more and 30 parts by weight or less based on 100 parts by weight of the entire resin composition, and by making the incorporated amount to be within this range, favorable thermal conductivity and electrical conductivity can be obtained, while also resulting in superior workability. In the case the incorporated amount of the insulating particles (C) is less than 5 parts by weight, the metal particles (B) may be unable to be aligned in parallel with the direction of gravity, while if the incorporated amount exceeds 30 parts by weight, the viscosity of the resin composition becomes high and workability decreases, and since a cured product of the resin composition may also become brittle, soldering resistance may decrease, thereby making this undesirable.

Specific examples of inorganic fillers include aluminum nitride, calcium carbonate, silica and alumina. The inorganic filler is preferably able to cause the metal particles (B) to align, and in the case of semiconductor applications, those having a uniform particle diameter are even more preferable. In addition, the inorganic filer is more preferably that for maintaining a constant thickness of the adhesive layer 1 by imparting a low coefficient of thermal expansion or low coefficient of moisture absorption and the like to the adhesive layer 1. Silica or alumina is particularly preferable.

Specific examples of organic fillers include styrene, styrene/isoprene, styrene/acrylic acid, methyl methacrylate, ethyl acrylate, acrylic acid, ethyl methacrylate, acrylonitrile, methacrylate, divinylbenzene, n-butylacrylate, nylon, silicone, urethane, melamine, cellulose, cellulose acetate, chitosan, acrylic rubber/methacrylate, ethylene, ethylene/acrylic acid, polypropylene or benzoguanamine, phenol, fluorine and vinylidene fluoride polymers.

The organic filler is preferably that which is able to cause the metal particles (B) to align, and in the case of semiconductor applications, that having a uniform particle diameter are even more preferable. In addition, the inorganic filer is more preferably that for maintaining a constant thickness of the adhesive layer 1 by imparting a low coefficient of thermal expansion or low coefficient of moisture absorption and the like to the adhesive layer 1. Crosslinked organic polymers composed mainly of poly(methyl methacrylate) are particularly preferable.

The resin composition in the present embodiment preferably further contains a coupling agent such as a silane coupling agent in the manner of epoxysilane, mercaptosilane, aminosilane, alkylsilane, ureidosilane or vinylsilane, a titanate coupling agent, an aluminum coupling agent or an aluminum/zirconium coupling agent.

Other additives may also be used in the resin composition in the present embodiment as necessary. Examples of other additives include colorants such as carbon black, low stress components such as silicone oil or silicone rubber, inorganic ion exchangers such as hydrotalcite, antifoaming agents, surfactants, various types of polymerization inhibitors and antioxidants, and these various additives may be suitably incorporated.

In addition, organic compounds can also be added to the resin composition in the present embodiment as necessary within a range that does not have an effect on the alignment of the metal particles (B) when in the form of a cured product. Examples thereof include hexane, 2-methylpentane, 2,2-dimethylbutane, 2,3-dimethylbutane, heptane, octane, 2,2,3-trimethylpentane, isooctane, nonane, 2,2,5-trimethylhexane, decane, 1-hexene, 1-heptene, 1-octene, 1-nonene, 1-decent, ethylbenzene, cumene, mesitylene, butylbenzene, p-cymene, diethylbenzene, methylcyclopentane, cyclohexane, methylcyclohexane, ethylcyclohexane, p-menthane, cyclohexene, α-pinene, dipentene, decaline, methanol, ethanol, 1-propanol, 2-propanol, 1-butanol, 2-butanol, isobutyl alcohol, tert-butyl alcohol, 1-pentanol, 2-pentanol, 3-pentanol, 2-methyl-1-butanol, isopentyl alcohol, tert-pentyl alcohol, 3-methyl-2-butanol, neopentyl alcohol, 1-hexanol, 2-methyl-1-pentanol, 4-methyl-2-pentanol, 2-ethyl-1-butanol, 1-heptanol, 2-heptanol, 3-heptanol, 1-octanol, 2-octanol, 2-ethyl-1-hexanol, 3,5,5-trimethyl-1-hexanol, cyclohexanol, 1-methylcyclohexanol, 2-methylcyclohexanol, 3-methylcyclohexanol, 4-methylcyclohexanol, abietinol, 1,2-ethanediol, 1,2-propanediol, 1,2-butanediol, 2-methyl-2,4-pentanediol, dipropyl ether, diisopropyl ether, dibutyl ether, anisole, phenetole, methoxytoluene, benzyl ethyl ether, 2-methylfuran, tetrahydrofuran, tetrahydropyran, 1,2-dimethoxyethane, 1,2-diethoxyethane, diethylene glycol dimethyl ether, diethylene glycol diethyl ether, acetal, acetone, methyl ethyl ketone, 2-pentanone, 3-pentanone, 2-hexanone, methyl isobutyl ketone, 2-heptanone, 4-heptanone, diisobutyl ketone, acetonitrile acetone, mesityl oxide, phorone, cyclohexanone, methylcyclohexanone, propionic acid, butyric acid, isobutyric acid, pivalic acid, valeric acid, isovaleric acid, 2-ethylbutyric acid, propionic anhydride, butyric anhydride, ethyl formate, propyl formate, butyl formate, isobutyl formate, pentyl formate, methyl acetate, ethyl acetate, propyl acetate, isopropyl acetate, butyl acetate, isobutyl acetate, sec-butyl acetate, pentyl acetate, isopentyl acetate, 3-methoxybutyl acetate, sec-hexyl acetate, 2-ethylbutyl acetate, 2-ethylhexyl acetate, cyclohexyl acetate, methyl propionate, ethyl propionate, butyl propionate, isopentyl propionate, methyl butyrate, ethyl butyrate, butyl butyrate, isopentyl butyrate, isobutyl isobutyrate, ethyl 2-hydroxy-2-methyl propionate, ethyl isovalerate, isopentyl isovalerate, methyl benzoate, diethyl oxalate, diethyl malonate, ethylene glycol monoacetate, ethylene diacetate, monoacetin, diethyl carbonate, nitromethane, nitroethane, 1-nitropropane, 2-nitropropane, acetonitrile, propionitrile, butyronitrile, isobutyronitrile, valeronitrile, benzonitrile, diethylamine, triethylamine, dipropylamine, diisopropylamine, dibutylamine, diisobutylamine, aniline, N-methylaniline, N,N-dimethylaniline, pyrrole, piperidine, pyridine, $\alpha$-picoline, $\beta$-picoline, $\gamma$-picoline, 2,4-lutidine, 2,6-lutidine, N-methylformamide, N,N-dimethylformamide, N,N-diethylformamide, N,N-dimethylacetoamide, dimethylsulfoxide, 2-methoxymethanol, 2-ethoxymethanol, 2-(methoxymethoxy)ethanol, 2-isopropoxyethanol, 2-butoxyethanol, 2-(thiopentyloxy)ethanol, furfuryl alcohol, tetrahydrofurfuryl alcohol, diethylene glycol monomethyl ether, 1-methoxy-2-propanol, 1-ethoxy-2-propanol, dipropylene glycol monomethyl ether, dipropylene glycol monoethyl ether, diacetone alcohol, 2-(dimethylamino)ethanol, 2-(diethylamino)ethanol, morpholine, N-ethylmorpholine, methyl lactate, ethyl lactate, butyl lactate, pentyl lactate, 2-methoxyethyl acetate, 2-ethoxyethyl acetate, 2-butoxyethyl acetate, methyl acetoacetate and ethyl acetoacetate. These can be used without any particular limitations, and two or more types may be used in combination.

The resin composition in the present embodiment can be produced by, for example, preliminarily mixing each component followed by kneading using a 3-roll roller and degassing in a vacuum.

The viscosity of the resin composition is preferably 1 Pa •s or more and 100 Pa•s or less. An adhesive layer of favorable thickness cannot be obtained after coating if the viscosity is lower or higher than that indicated above, thereby making this undesirable. Here, the value of viscosity refers to the value obtained by measuring with a type E viscometer (Toki Sangyo Co., Ltd., 3° cone) at 25°C and 2.5 rpm. More preferably, the range of viscosity is 2 Pa•s or more and 90 Pa•s or less and more preferably 2 Pa•s or more and 80 Pa•s or less.

In addition, the rate of change in viscosity of the resin composition before and after allowing to stand for 24 hours at 25°C is preferably 100% or less. If the rate of change in viscosity exceeds 100%, problems may occur with workability when coating the resin composition on a base material 2 or a semiconductor element 3 or with the accuracy of thickness after coating. Furthermore, allowing to stand for 24 hours at 25°C specifically refers to placing 5 g of the resin composition onto a glass plate, spreading to a thickness of 100 $\mu$m with a spatula and allowing to stand for 24 hours at 25°C.

(Semiconductor Device)

Next, an explanation is provided of a semiconductor device manufactured using the resin composition in the present embodiment. FIG. 1 is a cross-sectional view showing the configuration of a semiconductor device 10 in the present embodiment.

The semiconductor device 10 in the present embodiment is provided with the base material 2, the semiconductor element 3 and the adhesive layer 1 that adheres the base material 2 and the semiconductor element 3 while interposed there between.

The adhesive layer 1 is formed by coating the resin composition in the present embodiment on a semiconductor element or base material and compression bonding the semiconductor element 3 and the base material 2.

Although there are no particular limitations thereon, the thinkness of the adhesive layer 1 is preferably $\mu$m or more and 100 $\mu$m or less and more preferably 2 $\mu$m or more and 30 $\mu$m or less. As a result of making the thickness to be equal to or greater than the lower limit value, greater adhesive strength can be demonstrated. In addition, as a result of making the thickness to be equal to or less than the upper limit value, electrical conductivity and thermal conductivity can be further improved.

Although there are no particular limitations thereon, examples of the base material 2 include a lead frame such as an alloy 42 lead frame or copper lead frame, a heat dissipating member such as a heat sink or heat spreader, an organic substrate such as a glass epoxy substrate (substrate composed of glass fiber-reinforced epoxy resin) or BT substrate (substrate using a BT resin composed of a cyanate monomer and oligomer thereof and bismaleimide), other semiconductor elements, a semiconductor wafer and a spacer. Among these, a lead frame, heat sink or organic substrate that is able to more effectively demonstrate electrical conductivity and thermal conductivity of the adhesive layer 1 is preferable. Moreover, the organic substrate is preferably a BGA (ball grid array) substrate.

The semiconductor element 3 is electrically connected to a lead 4 through pads 7 and bonding wires 6. In addition, the periphery of the semiconductor element 3 is sealed by a sealing material layer 5.

In conventional resin compositions, it is difficult to coat a suitable amount of the resin composition particularly in the case of adhering a semiconductor element having a narrow chip width, and there were cases in which the resin composition protruded from the semiconductor element.

Since the resin composition in the present embodiment undergoes little change in viscosity and has superior workability, it is suitable for adhering a semiconductor element having a narrow chip width. Consequently, although there are no particular limitations thereon, the semiconductor element 3 is preferably a semiconductor element having a chip

width of 2 μm or less, such as a light-emitting diode element or semiconductor laser element.

(Method of Manufacturing Semiconductor Device Using Resin Composition)

There are no particular limitations on the method of manufacturing a semiconductor device 10 using the resin composition in the present embodiment, and a known method can be used. For example, after coating the resin composition at a prescribed site on the base material 2 by dispensing or stamping using a commercially available die bonder, the base material 2 and the semiconductor element 3 are subjected to compression bonding followed by heat-curing to form the adhesive layer 1.

Subsequently, wire bonding is carried out followed by forming the sealing material layer 5 using an epoxy resin to manufacture the semiconductor device 10. Alternatively, a method can also be employed in which the resin composition can be coated by dispensing or stamping onto the back of a semiconductor chip such as a flip-chip ball grid array (BGA) sealed with an underfill material after bonding the flip-chip, followed by mounting a heat dissipating component such as heat spreader or lid and heat-curing.

Here, dispensing refers to a coating method consisting of filling the inside of the cylinder of a die bonder with a resin composition, and then extruding the resin composition with a piston or pneumatic pressure to discharge a prescribed amount of the resin composition at a prescribed location on at least one surface of the base material 2 or the semiconductor element 3.

In addition, stamping refers to a coating method consisting of pressing the end of a transfer pin against the resin composition, and after moving the end of the transfer pin attached to the resin composition to directly over a prescribed location on at least one surface of the base material 2 or the semiconductor element 3, coating the resin composition onto at least one adhered side of the base material 2 or the semiconductor element 3 by pressing the transfer pin against it.

In addition, in the case of adhering a semiconductor element having a chip width of 2 μm or less, the resin composition is preferably coated by dispensing or stamping using an extremely fine needle. Since the resin composition in the present embodiment undergoes little change in viscosity and has superior workability, a small amount of the resin composition can be coated onto a substrate with favorable accuracy with respect to thickness by dispensing or stamping using an extremely fine needle.

Examples

Although the following indicates specific examples relating to the present embodiment, the present invention is not limited thereto. Each of the resin composition components indicated below are used in the present examples.

1. Thermosetting Resins

Epoxy Resin A: Bisphenol F epoxy resin (Nippon Kayaku Co. , Ltd., RE-303S)
Epoxy Resin B: m,p-cresyl glycidyl ether (Sakamoto Yakuhin Kogyo Co., Ltd., CGE, epoxy equivalent: 165)
Acrylic Resin A (Acrylate A) : Diacrylate (Kyoeisha Chemical Co., Ltd., Light Ester 4EG)
Acrylic Resin B (Acrylate B): Hydroxyl group-containing acrylate (Nihon Kasei Co., Ltd., CHDMMA)
Acrylic Resin C (Acrylate C): Carboxyl group-containing acrylate (Kyoeisha Chemical Co., Ltd., Light Ester HOMS)
Acrylic Resin D (Acrylate D): Triacrylate (Kyoeisha Chemical Co., Ltd., Light Ester TMP)
Maleimide Resin (Maleimide Compound): Maleimide compound (Dainippon Ink & Chemicals Inc., MIA-200)
Allyl Ester Resin (Allyl Ester Compound): Allyl ester compound (Showa Denko K.K., DA101)

2. Additives

Curing Agent A (Epoxy Curing Agent A): Bisphenol F (Dainippon Ink & Chemicals Inc., BPF, hydroxyl equivalent: 100)
Curing Agent B (Epoxy Curing Agent B): Dicyandiamide (Adeka Corp., DDA)
Curing Catalyst (Epoxy Catalyst A): 2-phenyl-4-methyl-5-hydroxymethyl imidazole (Shikoku Chemicals Corp., Curazol 2P4MHZ)
Coupling Agent A: Epoxysilane (Shin-Etsu Chemical Co., Ltd., KBM-403E)
Coupling Agent B: Bis(trimethoxysilylpropyl)tetrasulfide (Daiso Co., Ltd., Cabrus 4)
Coupling Agent C: Vinylsilane coupling agent (Shin-Etsu Chemical Co., Ltd., KBM-503P)

Polymerization Initiator (Peroxide) : Peroxide (Kayaku Akzo Corp., Perkadox BC)

3. Metal Particles

Flaked Silver Particles A (Flaked Particles A): (Fukuda Metal Foil & Powder Co., Ltd., Agc-TC6, $d_{50}$: 14.0 $\mu$m, $d_{95}$: 23.0 $\mu$m, 10 $\mu$m < 13%)
Flaked Silver Particles B (Flaked Particles B) : Ferro Corp., SF-78, $d_{50}$: 9.5 $\mu$m, $d_{95}$: 14.0 $\mu$m, 10 $\mu$m < 54%)
Flaked Silver Particles C (Flaked Particles C) : Ferro Corp., SF-65, $d_{50}$: 4.0 $\mu$m, $d_{95}$: 13.0 $\mu$m, 10 $\mu$m < 12%)
Flaked Silver Particles D (Flaked Particles D): (Fukuda Metal Foil & Powder Co., Ltd., Agc-2611, $d_{50}$: 3.7 $\mu$m, $d_{95}$: 8.5 $\mu$m, 10 $\mu$m < 5%)
Flaked Silver Particles E (Flaked Particles E): (Dowa Electronics Materials Co., Ltd., FA-S-6, $d_{50}$: 2.2 $\mu$m, $d_{95}$: 6.0 $\mu$m, 10 $\mu$m < 0%)
Spherical Silver Particles A (Dowa Electronics Materials Co., Ltd., AG2-1C, $d_{50}$: 1.7 $\mu$m, $d_{95}$: 3.6 $\mu$m, 10 $\mu$m < 0%)

4. Insulating Particles

Crosslinked PMMA-1: (Art Pearl GR-800, 10 $\mu$m < 7%)
Crosslinked PMMA-2: (Art Pearl SE-006T, 10 $\mu$m < 4%)
Crosslinked PMMA-3: (Art Pearl J-7P, 10 $\mu$m < 0%)

Here, the X of 10 $\mu$m < X% represents the volume ratio of metal particles or insulating particles having a particle diameter that exceeds 10 $\mu$m.
Furthermore, particle diameter was measured under the following conditions using the Flow-Type Particle Image Analyzer FPIA-3000 manufactured by Hosokawa Micron Ltd.

Measuring mode: HPF
Quantitative count
Object lens: 20X
Optical system: Bright field
Temperature: Room temperature
Pressure: 0.22 MPa

[Examples 1 to 13 and Comparative Examples 1 to 3]

The aforementioned components were blended in the ratios shown in Table 1 followed by kneading with a 3-roll roller and degassing for 15 minutes at 2 mmHg in a vacuum chamber to produce each resin composition. Blending ratios are in parts by weight.

(Evaluation Tests)

The following evaluation tests were carried out on each of the resin compositions obtained in the manner described above. The evaluation results are shown in Table 1.

(Viscosity)

Values were measured at 25°C and 2.5 rpm using a type E viscometer (3° cone) immediately after producing the aforementioned resin compositions. In addition, values were similarly measured at 25°C and 2.5 rpm after allowing the produced resin compositions to stand for 24 hours at 25°C, and the rate of change in viscosity after 24 hours was calculated. Furthermore, allowing to stand for 24 hours at 25°C specifically refers to placing 5 g of resin composition on a glass plate, spreading to a thickness of 100 $\mu$m with a spatula and allowing to stand for 24 hours at 25°C.

$$\text{Rate of change in viscosity after 24 hours [\%]} = 100 \times$$

$$\text{(viscosity after standing for 24 hours} - \text{viscosity}$$

$$\text{Immediately after production)/(viscosity immediately}$$

$$\text{after production)} \qquad\qquad (1)$$

(Dischargeability)

Workability was evaluated when discharging the resin compositions using an extremely fine needle having an inner nozzle diameter of 100 $\mu$m and a dispenser. The following abbreviations were used to evaluate dischargeability.
OK: No problems with resin composition discharge rate or spreading
NG: Resin composition unable to be discharged

[Table 1]

| | Examples | | | | | | | | | | | | | Comparative Examples | | |
|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 1 | 2 | 3 |
| Epoxy Resin A | 13.3 | 13.3 | 10.6 | 8.0 | 10.6 | 53.2 | | 14.9 | | 14.9 | | 14.9 | | 13.3 | 8.0 | 13.3 |
| Epoxy Resin B | 8.0 | 8.0 | 6.4 | 4.8 | 6.4 | 31.9 | | 8.9 | | 8.9 | | 8.9 | | 8.0 | 4.8 | 8.0 |
| Epoxy Curing Agent A | 2.7 | 2.7 | 2.1 | 1.6 | 2.1 | 10.6 | | 3.0 | | 3.0 | | 3.0 | | 2.7 | 1.6 | 2.7 |
| Epoxy Curing Agent B | 0.3 | 0.3 | 0.2 | 0.2 | 0.2 | 1.1 | | 0.3 | | 0.3 | | 0.3 | | 0.3 | 0.2 | 0.3 |
| Epoxy Catalyst A | 0.3 | 0.3 | 0.2 | 0.2 | 0.2 | 1.1 | | 0.3 | | 0.3 | | 0.3 | | 0.3 | 0.2 | 0.3 |
| Coupling Agent A | 0.5 | 0.5 | 0.4 | 0.3 | 0.4 | 2.1 | | 0.6 | | 0.6 | | 0.6 | | 0.5 | 0.3 | 0.5 |
| Acrylate A | | | | | | | 1.9 | | 2.2 | | 2.2 | | 2.2 | | | |
| Acrylate B | | | | | | | 2.6 | | 3.0 | | 3.0 | | 3.0 | | | |
| Acrylate C | | | | | | | 1.0 | | 1.1 | | 1.1 | | 1.1 | | | |
| Acrylate D | | | | | | | 0.5 | | 0.5 | | 0.5 | | 0.5 | | | |
| Maleimide Compound | | | | | | | 6.0 | | 6.7 | | 6.7 | | 6.7 | | | |
| Allyl Ester Compound | | | | | | | 12.0 | | 13.5 | | 13.5 | | 13.5 | | | |
| Coupling Agent B | | | | | | | 0.7 | | 0.8 | | 0.8 | | 0.8 | | | |
| Coupling Agent C | | | | | | | 0.1 | | 0.1 | | 0.1 | | 0.1 | | | |
| Peroxide | | | | | | | 0.1 | | 0.1 | | 0.1 | | 0.1 | | | |
| Flaked Silver Particles A (10 $\mu$m < 13%) | | | | | | | | | | | | | | 75.0 | 85.0 | 65.0 |
| Flaked Silver Particles B (10 $\mu$m < 54%) | | | | | | | | | | | | | | | | 5.0 |
| Flaked Silver Particles C (10 $\mu$m < 12%) | | | | | | | | | | | | | | | | 5.0 |
| Flaked Silver Particles D (10 $\mu$m < 5%) | 75.0 | | | | | | | | | | | | | | | |
| Flaked Silver Particles E (10 $\mu$m < 0%) | | 75.0 | 80.0 | 85.0 | | 30.0 | 75.0 | | | | | | | | | |
| Spherical Particles A (10 $\mu$m < 0%) | | | | | 80.0 | 50.0 | | 60.0 | 60.0 | 60.0 | 60.0 | 60.0 | 60.0 | | | |
| Crosslinked PMMA-1 (10 $\mu$m < 7%) | | | | | | | | | | | | 12 | 12 | | | |
| Crosslinked PMMA-2 (10 $\mu$m < 4%) | | | | | | | | | | 12 | 12 | | | | | |
| Crosslinked PMMA-3 (10 $\mu$m < 0%) | | | | | | | | 12 | 12 | | | | | | | |

EP 2 717 304 A1

14

(continued)

| | Examples | | | | | | | | | | | | | Comparative Examples | | |
|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 1 | 2 | 3 |
| Percentage of Particles > 10 $\mu$m in Paste | 3.8 | 0.0 | 0.0 | 0.0 | 0.0 | 0.0 | 0.0 | 0.0 | 0.0 | 1.8 | 1.8 | 4.4 | 4.3 | 9.8 | 11.1 | 11.8 |
| $d_{95}$ ($\mu$m) of particles in paste | 8.5 | 6.0 | 6.0 | 6.0 | 3.6 | 5.0 | 6.0 | 4.1 | 4.0 | 5.5 | 5.2 | 7.3 | 7.5 | 23.0 | 23.0 | 20.0 |
| Viscosity (type E, 2.5 rpm, PaS) | 7 | 18.4 | 31.8 | 68.6 | 78 | 35 | 14.3 | 40.4 | 25.1 | 32.1 | 25.1 | 28.5 | 22.1 | 29.2 | 107.8 | 33 |
| Rate of change in viscosity after 24 hours (%) | 57 | 41 | 74 | 88 | 5 | 10 | -8 | 13 | 11 | 48 | 43 | 61 | 59 | 245 | 262 | 153 |
| 32G (100 $\mu$m diameter) dischargeability | OK | OK | OK | OK | OK | OK | OK | OK | OK | OK | OK | OK | OK | NG | NG | NG |

As is clear from Table 1, the resin compositions of Examples 1 to 13 demonstrated small rates of change in viscosity, exhibited favorable dischargeability and had superior workability. In addition, these resin compositions demonstrated superior workability even during die bonding of a semiconductor element having a chip width of 2 $\mu$m or less.

INDUSTRIAL APPLICABILITY

According to the present invention, the present invention is extremely industrially useful since it provides a resin composition having superior workability.

REFERENCE SIGNS LIST

1    Adhesive layer
2    Base material
3    Semiconductor element
4    Lead
5    Sealing material layer
6    Bonding wire
7    Pad
10   Semiconductor device

**Claims**

1. A paste-like resin composition that adheres a semiconductor element and a base material, comprising:

   a thermosetting resin, and
   a metal particle; wherein,
   $d_{95}$ in the volume-based particle size distribution of the metal particle as determined with a flow-type particle image analyzer is 10 $\mu$m or less.

2. The resin composition according to claim 1, wherein
   the median diameter $d_{50}$ of the metal particle in a volume-based particle size distribution as determined with a flow-type particle image analyzer is 0.5 $\mu$m or more and 8 $\mu$m or less.

3. The resin composition according to claim 1 or claim 2, wherein
   the rate of change in viscosity of the resin composition before and after allowing to stand for 24 hours at 25°C is 100% or less.

4. The resin composition according to any of claims 1 to 3, wherein
   the metal particle include silver particle.

5. The resin composition according to any of claims 1 to 4, wherein
   the resin composition further contains one or more types of insulating particle selected from silica particle, alumina and organic polymer.

6. The resin composition according to any of claims 1 to 5, wherein
   the thermosetting region includes epoxy resin.

7. The resin composition according to any of claims 1 to 6, wherein
   the resin composition is used for stamping the resin composition on at least one adhered side of the semiconductor element and the base material by transferring and coating with a transfer pin.

8. A semiconductor device provided with:

   the base material,
   the semiconductor element, and

an adhesive layer that adheres the base material and the semiconductor element while interposed there between; wherein,
the adhesive layer is formed using the resin composition of any of claims 1 to 7.

9. The semiconductor device according to claim 8, wherein the chip width of the semiconductor element is 2 $\mu$m or less.

10. The semiconductor device according to claim 8 or claim 9, wherein
the semiconductor element is a light-emitting diode element or a semiconductor laser element.

11. The semiconductor device according to any of claims 8 to 10, wherein
the base material is a lead frame, heat sink or BGA substrate.

12. A method of manufacturing a semiconductor device of any of claims 8 to 11, comprising:

a step for coating the resin composition onto at least one adhered side of the semiconductor element or the base material, and
a step for forming the adhesive layer by compression bonding the semiconductor element and the base material followed by heat curing.

13. The method of manufacturing a semiconductor device according to claim 12, wherein
the step for coating the resin composition includes stamping the resin composition by transferring with a transfer pin or dispensing with an extremely fine needle.

# FIG. 1

EP 2 717 304 A1

<div style="text-align:center">**INTERNATIONAL SEARCH REPORT**</div>

| | International application No. |
|---|---|
| | PCT/JP2012/063631 |

**A. CLASSIFICATION OF SUBJECT MATTER**
*H01L21/52*(2006.01)i, *C09J11/04*(2006.01)i, *C09J163/00*(2006.01)i, *C09J201/00*(2006.01)i

According to International Patent Classification (IPC) or to both national classification and IPC

**B. FIELDS SEARCHED**

Minimum documentation searched (classification system followed by classification symbols)
H01L21/52, C09J11/04, C09J163/00, C09J201/00

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 5-36307 A (Fukuda Metal Foil & Powder Co., Ltd.),<br>12 February 1993 (12.02.1993),<br>table 1; paragraphs [0001], [0006], [0007]<br>(Family: none) | 1-4,6,7<br>1-13 |
| Y | JP 5-89721 A (Miyazaki Oki Electric Co., Ltd.),<br>09 April 1993 (09.04.1993),<br>claims; fig. 1, 3; paragraph [0008]<br>(Family: none) | 1-13 |
| A | JP 2003-16838 A (Sumitomo Bakelite Co., Ltd.),<br>17 January 2003 (17.01.2003),<br>claims; table 1; paragraph [0006]<br>& US 2003/0122257 A1 & DE 10228484 A<br>& DE 10228484 A1 & TW 233620 B<br>& CN 1395259 A & SG 104973 A | 1-13 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>13 June, 2012 (13.06.12) | Date of mailing of the international search report<br>26 June, 2012 (26.06.12) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 717 304 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011121386 A
- JP H0589721 B
- JP H07118616 B